# EUROPEAN PATENT APPLICATION

(11) **EP 2 587 560 A1**
(43) Date of publication of application: **01.05.2013**
(21) Application number: 11186646.3
(22) Date of filing: 26.10.2011
(51) Int. Cl.: H01L 33/56, H01L 33/54, H01L 33/32

(54) **Light emitting diode**

(71) Applicant: Forschungsverbund Berlin e.V., 12489 Berlin (DE)
(72) Inventor: Kneissl, Michael, 10435 Berlin (DE); Lobo, Neysha, 13627 Berlin (DE)
(74) Representative: Gulde Hengelhaupt Ziebig & Schneider

(57) **Abstract**

The present invention relates to an encapsulant for ultraviolet light emitting diodes. It is an object of the present invention to provide an encapsulant for UV LEDs emitting below 350 nm resulting in an increased extraction efficiency of the LED. According to the invention, a light emitting diode is disclosed comprising a radiation zone (12) which is electrically connected to a first contact (14) and to a second contact (16), and an encapsulant (18) encapsulating at least part of the radiation zone (12), the first contact (14) and the second contact (16), wherein the encapsulant (18) comprises polydimethylsiloxane.

## Description

### Field

The present invention relates to an encapsulant for ultraviolet (UV) light emitting diodes (LED).

### Description of the Related Art

LEDs are used in diverse applications, from solid state lighting to sensing due to their low energy consumption, long lifetime, robustness, small size, fast switching, durability, and reliability.

LEDs emitting in the UV region are of particular interest as replacements for mercury lamps in the fields of sterilization and water purification. However UV LEDs are relatively expensive as compared to other UV sources due to the low external quantum efficiency of the devices and the cost involved in the packaging of the LEDs. If these challenges are overcome, UV LEDs can be used for photo curing of dies and resins, sensing of gases, phototherapy and many other applications.

The extraction efficiency of conventional UV LEDs emitting in the UV-B and UV-C region ranges from 4% to 10 %. A conventional technique for increasing the extraction efficiency of LEDs by a factor of 2 to 3 is the use of high refractive index encapsulants. However, the optical transmission (hereinafter also referred to as optical transparency) of conventionally used epoxies or silicones for said encapsulants significantly decreases at wavelengths shorter than 350 nm. Prolonged exposure to the UV light also degrades the conventional encapsulant which results in a further decrease in the optical transparency.

As conventional silicones are either strongly absorbing or degrade rapidly in the deep UV region, they are not used in the manufacture of UV LEDs emitting below 350 nm. Currently, for the packaging of deep UV LEDs emitting below 350 nm, simple metal-glass cans, with UV transparent quartz windows or a UV transparent quartz lens are used. While being an effective packaging solution, the light extraction efficiency is much lower than that of near UV and visible LEDs which use easily mouldable silicones or epoxies as structured encapsulants.

It is therefore an object of the present invention to provide an encapsulant for UV LEDs emitting below 350 nm resulting in an increased extraction efficiency of the LED.

### SUMMARY OF CERTAIN INVENTIVE ASPECTS

According to an aspect of the present invention, polydimethylsiloxane (PDMS) is used as an encapsulant for UV LEDs, which is highly transparent in the entire UV-A and UV-B and at least part of the UV-C and is resistant to UV light. With the use of PDMS, a 2 to 3 fold increase in the extraction efficiencies can be achieved and the lifetime of the UV LEDs will not be limited by degradation of the encapsulant. Accordingly the use of PDMS (preferably along with other techniques to increase light extraction e.g. nanopixel LEDs) results in external quantum efficiencies (EQE) ranging from 20 % to 40 % which greatly exceeds the conventional deep UV LEDs emitting below 350 nm. In addition, the cost for an UV LED package will also be much cheaper with PDMS compared to a conventional solution using metal can with quartz windows (particularly the quartz window or lenses are very expensive).

In the sense of the present invention, UV-A is understood as a wavelength range of 400 to 315 nm, UV-B is understood as a wavelength range of 315 to 280 nm and UV-C is understood as a wavelength range of 280 to 100 nm.

Preferably the encapsulant of the present invention is used for LEDs having a wavelength (with the maximum emission intensity) in the range of 210 to 400 nm.

The present invention discloses a light emitting diode comprising a radiation zone located between a first contact and a second contact, and an encapsulant encapsulating at least part of the radiation zone, the first contact and the second contact, wherein the encapsulant comprises polydimethylsiloxane. Preferably the encapsulant consists of polydimethylsiloxane (also referred to as PDMS). It is preferred that PDMS is cross-linked using a cross-linking chemical compound.

Preferably the encapsulant completely encapsulates the radiation zone, the first contact and the second contact. Preferably the radiation zone, the first contact and the second contact are completely buried within the encapsulant. Preferably at least one of the radiation zone, the first contact and the second contact (at least partly) directly contact the encapsulant.

Preferably the light emitting diode further comprises a mount, wherein the radiation zone, the first contact and the second contact are completely encapsulated between the mount and the encapsulant. Preferably the encapsulant is the outermost component of the light emitting diode through which the light emitted by the radiation zone passes when being extracted from the light emitting diode. That is, there are preferably no further layers or components attached to the outer surface of the encapsulant (which faces away from the radiation zone).

Preferably the radiation zone comprises at least one inorganic material. Preferably the radiation zone consists of at least one inorganic material. That is, preferably the light emitting diode is an inorganic emitting diode where no organic material is used for electroluminescence.

An inorganic LED is a semiconductor light source. LEDs are used as indicator lamps in many devices and are increasingly used for other lighting. When a light emitting diode is forward biased (switched on), electrons are able to recombine with electron holes within the device, releasing energy in the form of photons. This effect is called electroluminescence and the color of the light (corresponding to the energy of the photon) is determined by the energy gap of the semiconductor.

The LED preferably comprises a small radiation zone surface area (preferably less than 5 mm², more preferably less than 1 mm²) and integrated optical components may be used to shape its radiation pattern.

Preferably the inorganic light emitting diode comprises a semiconducting inorganic multi-layer diode material that is driven in forward bias. Light is emitted in a lambertian pattern and a cone-like shaped encapsulant is preferably used to focus the light in the forward direction. Preferably the radiation zone comprises aluminum indium gallium nitride or any of the combinations of AlGaN, InAlN and/or AllnGaN. Preferably the radiation zone consists of aluminum indium gallium nitride or any of the combinations of AlGaN, InAlN and/or AllnGaN.

Preferably the encapsulant is formed with a convex top surface. More preferably, the encapsulant is formed with a top surface being axially symmetrical to an axis extending perpendicular to a central portion of the mount. Preferably the mount comprises a planar top surface. More preferably, the encapsulant is formed with a hemispherical top surface.

Preferably the encapsulant directly contacts the mount in a peripheral portion. Preferably a circumferential line of a peripheral portion, where the encapsulant and the mount contact each other, forms a circle.

Preferably the maximum lateral extension of the encapsulant ranges between 0.2 and 10 mm. In case, the encapsulant is formed with a circular circumferential line, the diameter of the encapsulant preferably ranges between 0.2 and 5.0 mm. Preferably the light emitting diode according further comprises a submount which is formed to directly contact the mount. The submount has a size smaller than that of the mount. Accordingly, the submount is (preferably) also completely embedded between the encapsulant and the mount. Preferably, the surface area of a surface which is enclosed within the circumferential line (where mount and encapsulant are contacting each other) ranges between 300 and 10000% (preferably between 300 and 1000%) of the contacting surface area between mount and submount. The mount and/or the submount may be formed of ceramics. The mount and/or the submount may be formed of diamond or WCu. Preferably, the light emitting diode comprising the first contact, the second contact and the radiation zone are attached to the submount.

The extraction efficiency of LEDs emitting in the UV-B and UV-C region will be greatly increased and a long term stability of the encapsulant will be achieved.

### BRIEF DESCRIPTION OF THE DRAWINGS

FIG. 1 is a perspective view of a light emitting diode according to an exemplary embodiment of the present invention,
FIG. 2 is a cross-sectional view of the light emitting diode according to FIG. 1,
FIG. 3 is a cross-sectional view of a light emitting diode according to another exemplary embodiment of the present invention, and
FIG. 4 is a graph of the measured transmission spectrum of a 1 mm thick PDMS film cured at 100°C.

### DETAILED DESCRIPTION OF THE DRAWINGS

The present invention will be described more fully hereinafter with reference to the accompanying drawings, in which exemplary embodiments of the invention are shown. As those skilled in the art would realize, the described embodiments may be modified in various different ways, all without departing from the scope of the present invention.

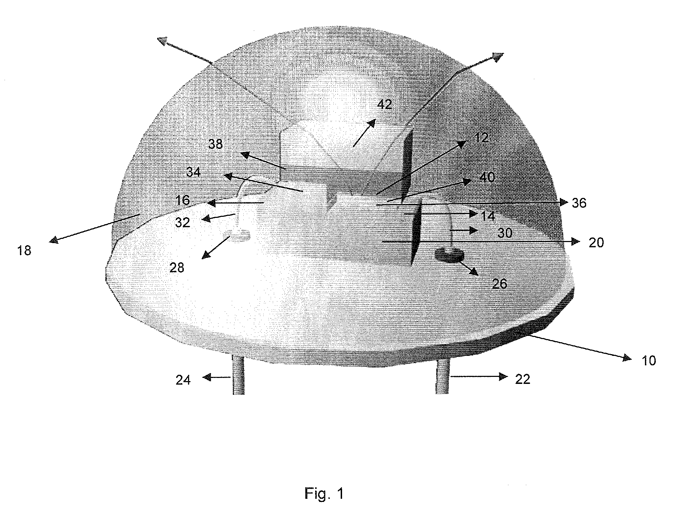

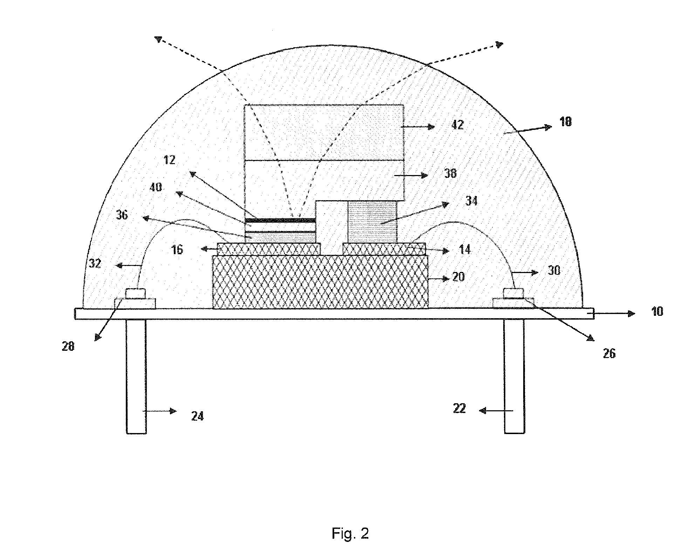

FIG. 1 and 2 are a perspective and a sectional view of a light emitting diode according to an exemplary embodiment of the present invention.

Referring to FIG. 1 and 2, the LED comprises a mount 10 on which a submount 20 is formed or bonded. A first contact 14 and a second contact 16 are formed on the submount 20. The first contact 14 and a second contact 16 are connected to wires 30, 32 which extend through the mount 10 thereby forming terminal contacts 22 and 24. The wires 30, 32 are formed to extend through via holes formed in the mount 10 having a seal 26 and 28 to avoid the penetration of oxygen or moisture into the inner portion of the light emitting diode and for electrical insulation in the case of a metallic mount. A radiation zone 12 is (electrically) formed between the first contact 14 and a second contact 16. The first contact 14 and the second contact 16 are formed by a metal layer or a multiple layer of metals and the radiation zone 12 is formed of an inorganic semiconducting material.

The contacts 14 and 16 are contacts on the submount i.e. they are not p-type or n-type but identical in terms of composition. They may be single layer or multilayer. Each of the contact layers 14, 16 may comprise injectors adapted to inject charge carriers into the radiation zone 12.

The LED comprises a radiation zone 12 surrounded by a p-doped inorganic semiconductor layer 40 and a transparent n-doped inorganic semiconductor layer 38. Each of layer 38 and layer 40 may be formed as a multilayer. The p-metal contact layer 36 is fabricated on layer 40 and n- metal contact layer 34 is fabricated on layer 38. Each of layer 34 and layer 36 may be formed as a multilayer. The entire LED is grown on a substrate 42 which may be removed. The contacts 36 and 34 are bonded (soldered) to the submount pads 14 and 16.

An encapsulant 18 is formed to encapsulate the first contact 14, the second contact 16 and the radiation zone 12. The encapsulant 18 completely consists of polydimethylsiloxane. Preferably the PDMS is cross-linked using a cross-linking chemical compound. The encapsulant 18 is formed such that the components (first contact 14, the second contact 16 and the radiation zone 12) are completely embedded within the encapsulant 18. The lower surface of the encapsulant 18 directly contacts the upper surface of the mount 10. The upper surface of the encapsulant 18 is formed with a hemispherical shape.

When light is emitted in the radiation zone 12 of the LED, due to the high refractive index of the substrate 42, only the light incident on the surface at an angle which lies within the escape cone can be extracted. Light incident on the surface-air interface at an angle greater than the critical angle, undergoes total internal reflection and is lost due to re-absorption by defects, active region or absorbing layers. The critical angles for different substrate-air interfaces are given in Table 1.

**Table 1: Critical angle of total internal reflection for different semiconductor (substrate)/air (PDMS) interfaces calculated at 320 nm and 265 nm.**

| Interface | AlN/air | AlN/sapphire/air | AlN/sapphire/PDMS (N_{PDMS} = 1.38) | AIN/sapphire/PDMS (n_{PDMS} = 1.54) |
|---|---|---|---|---|
| Critical angle (320nm) | 26° | 26° | 38° | 43° |
| Critical angle (265nm) | 25° | 25° | 36° | 41° |

The extraction efficiency for a square UV LED structure with polished sapphire backside and opaque contacts is calculated to be less than 10%. In order to increase the extraction efficiency an optically transparent encapsulant 18, which decreases the index contrast at the surface-air interface thus increasing the escape cone, can be used.

Furthermore, if the geometry of the encapsulant 18 is chosen such (e.g. hemispherical dome structure) that the light is always incident normal to the encapsulant-air interface, the extraction efficiency can increase at least by a factor of 2 to 3. For UV LEDs the chosen encapsulant 18 should be optically transparent in the UV region, stable under UV exposure and mouldable and have a refractive index similar or close to that of the semiconductor material or the substrate. Preferably the ratio of the refractive index of the encapsulant 18 and the refractive index of the semiconducting material of the radiation zone 12 ranges between 0.2 and 5, more preferably between 0.5 and 2, more preferably between 0.8 and 1.2 and more preferably between 0.9 and 1.1. Still more preferably the refractive index of the encapsulant 18 is equal to the refractive index of the semiconducting material of the radiation zone 12 (with respect to the emitting wavelength of the light emitting diode, if the light emitting diode emits over a certain range, the refractive index is determined with respect to the wavelength of the maximum emitting intensity of the light emitting diode).

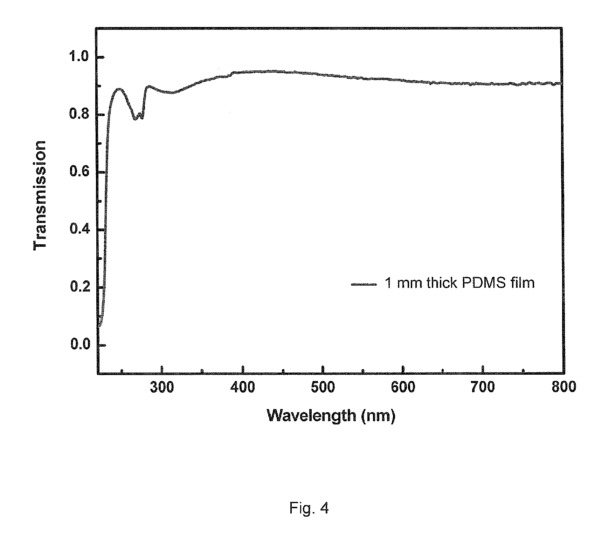

According to the present invention, polydimethylsiloxane (PDMS) is used as the encapsulant 18 for LEDs emitting from 235 nm to 550 nm. PDMS is an elastomeric material and belongs to the group of polymeric organosilicon compounds. As seen in Fig. 4, the transparency of PDMS is greater than 80 % in the wavelength range from 235 nm to 800 nm and its refractive index lies between 1.38 - 1.54. It is inert, non-flammable and non-toxic. Its adhesion to surfaces of different materials can be easily controlled as will be described below. PDMS is extensively used as a master mould for soft lithography due to its ease of use (easily mouldable) and low cost.

The PDMS can be moulded into different geometries using a master mould, for e.g. an aluminium block with hemispherical pits. A silicon wafer, with microscopic features made by conventional lithography, can also be used as a mould. In order to prevent the adhesion of PDMS to the mould, it should be coated with a layer of diluted detergent (anionic detergent with an alkyl group as the non-polar part and the polar functional group is -COO- (Carboxylate), -SO3- (Sulfonate) or -S042-(Sulfate)). A degassed mixture PDMS pre-polymer and curing agent can then be poured into the mould and cured at a suitable temperature between 70° C and 150° C. The hardened PDMS can be easily peeled off from the mould. The LED chip can then be adhered to the PDMS either during or after the curing.

The use of PDMS as an encapsulant for deep UV LEDs has the advantages that the use of an encapsulant will increase the light extraction efficiency from the LED chip by at least a factor of 2 to 3, it can also be moulded into a lens-like or dome-like structure to modify the emission pattern of the LEDs, it is easily mouldable, easy to handle and very inexpensive and as it is transparent in the visible region it can also be used for visible LEDs making it a standard packaging technique for LEDs emitting from 235 nm to 550 nm.

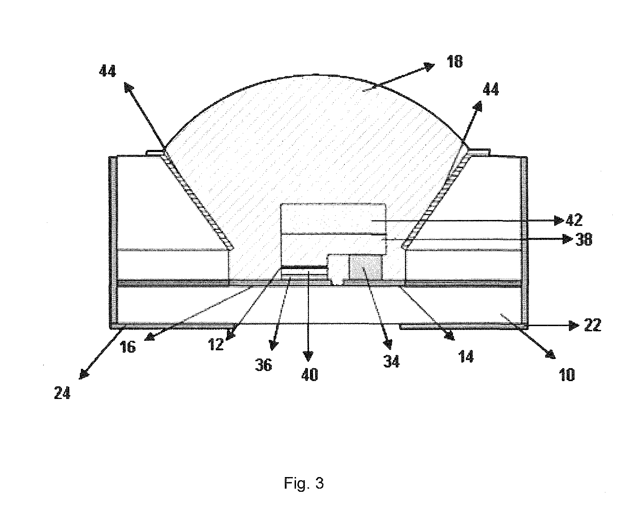

FIG. 3 is a cross-sectional view of a light emitting diode according to another exemplary embodiment of the present invention. In Fig 3, The LED chip is directly bonded to a ceramic mount (e.g. AIN, BN, SiC) without the use of a submount hence wires 30 and 32 are not needed. Seals 26 and 28 are also not needed as the electrical connects are fabricated in the ceramic mount itself. Reference signs 22 and 24 represent metal pads on the bottom of the mount used as terminal contacts adapted to electrically connect the LED to the outside. Metal pads 22 and 24 are connected to the mount pads 16 and 14 by metal connecting parts in the ceramic mount. The difference between the embodiment of Fig. 3 and the embodiment of Fig. 1 is that this is a surface mountable packaging with a reflector 44 to increase the collected light by reflecting the light outward. Reference signs 44 represent angled side wall(s) of the mount cavity which is coated with a metal layer or a multilayer (e.g. selected from any Au, Ag, Al or combinations thereof) in order to form a reflector which reflects the light emitted by the LED outward.

While an exemplary embodiment of the present invention has been described, the present invention is not limited to the embodiment and may be modified in various ways without departing from the scope of the appended claims, the detailed description, and the accompanying drawings of the present invention. Therefore, such modifications are obviously within the scope of the present invention.

### List of reference signs

- 10: Mount
- 12: Radiation zone (layers of inorganic semiconductors - AllnGaN)
- 14, 16: Metal pads (on submount)
- 18: PDMS encapsulant
- 20: Submount
- 22, 24: Terminal contacts
- 26,28: Seals
- 30, 32: bonding wires
- 34: n- metal contact layer/ multilayer
- 36: p- metal contact layer/ multilayer
- 38: Transparent n-doped InAlGaN layer / multilayer
- 40: p-doped InAlGaN layer / multilayer
- 42: Substrate (sapphire, Si, SiC, AIGaN or AIN)
- 44,46: Reflector
- 34 to 42: UV LED

## Claims

1. A light emitting diode comprising a radiation zone (12) which is electrically connected to a first contact (14) and to a second contact (16), and an encapsulant (18) encapsulating at least part of the radiation zone (12), the first contact (14) and the second contact (16),
**characterized in that**
the encapsulant (18) comprises polydimethylsiloxane.

2. The light emitting diode of claim 1, wherein the encapsulant (18) consists of polydimethylsiloxane.

3. The light emitting diode according to any one of the preceding claims, wherein the encapsulant (18) completely encapsulates the radiation zone (12), the first contact (14) and the second contact (16).

4. The light emitting diode according to any one of the preceding claims, further comprising a mount (10), wherein the radiation zone (12), the first contact (14) and the second contact (16) are completely encapsulated between the mount (10) and the encapsulant (18).

5. The light emitting diode according to any one of the preceding claims, the radiation zone (12) comprises at least one inorganic semiconducting material.

6. The light emitting diode according to any one of the preceding claims, the radiation zone (12) consists of at least one inorganic semiconducting material.

7. The light emitting diode according to any one of the preceding claims, wherein the radiation zone comprises aluminum gallium indium nitride.

8. The light emitting diode according to any one of the preceding claims, wherein the encapsulant (18) is formed with a convex top surface.

9. The light emitting diode according to any one of claims 4 to 8, wherein the encapsulant (18) is formed with a top surface being axially symmetrical to an axis extending perpendicular to a central portion of the mount (10).

10. The light emitting diode according to any one of the preceding claims, wherein the encapsulant (18) is formed with a hemispherical top surface.

11. The light emitting diode according to any one of the preceding claims, wherein the encapsulant (18) directly contacts the mount (10) in a peripheral portion.

12. The light emitting diode according to any one of the preceding claims, wherein a circumferential line of a peripheral portion of the contacting area of the encapsulant (18) and the mount (10) forms a circle.

13. The light emitting diode according to any one of the preceding claims, wherein diameter of the encapsulant (18) ranges between 0.2 and 5.0 mm.

14. The light emitting diode according to any one of the preceding claims, further comprising a submount (20).
